# EUROPEAN PATENT APPLICATION

(11) **EP 2 058 836 A1**
(43) Date of publication of application: **13.05.2009**
(21) Application number: 07120166.9
(22) Date of filing: 07.11.2007
(51) Int. Cl.: H01J 37/34

(54) **Sputter coating device and coating method**

(71) Applicant: Applied Materials, Inc., Santa Clara, CA 95054 (US)
(72) Inventor: Lindenberg, Ralph, 63654 Büdingen (DE); Bender, Marcus, 63454 Hanau (DE); Stolley, Tobias, 60598 Frankfurt am Main (DE); Kloeppel, Andreas, 63695 Glauburg (DE); Lopp, Andreas, 63579 Freigericht-Somborn (DE); Moelle, Christoph, 55131 Mainz (DE)
(74) Representative: Lermer, Christoph

(57) **Abstract**

A magnet/target assembly 1 comprises a target 2 consisting of a plurality of (virtual) segments 2.1, 2.2, 2.3, 2.4, 2.5, 2.6 arranged side by side, each of them extending along the longitudinal axis x of the target 2. Each of the plurality of target segments 2.1, 2.2, 2.3, 2.4, 2.5, 2.6 has a magnet system 3.1, 3.2, 3.3, 3.4, 3.5, 3.6 attributed to the respective target segment. In an embodiment of the target/magnet assembly 1 according to the present invention the magnet systems 3.1, 3.2, 3.3, 3.4, 3.5, 3.6 are arranged mutually offset relative to their respective adjacent magnet systems 3.1, 3.2, 3.3, 3.4, 3.5 and 3.6, respectively, while scanning the target segments 2.1, 2.2, 2.3, 2.4, 2.5 and 2.6, respectively. Particularly, the first magnet system 3.1, the third magnet system 3.3 and the fifth magnet system 3.5 are a first group of magnet systems moving parallel and synchronously with each other, and the second magnet system 3.2, the forth magnet systems 3.4 and the sixth magnet system 3.6 are a second group of magnet systems moving parallel and synchronously with each other. The first, third and fifth magnet systems 3.1, 3.3, 3.5 are alternately arranged with the second, forth and sixth magnet systems 3.2, 3.4 and 3.6, respectively, in the lateral direction y of the target 2. The paths of movement of the magnet systems are arranged parallel. The first and second groups of magnet systems 3.1, 3.2, 3.3, 3.4, 3.5, 3.6 are arranged offset in a longitudinal direction x of the target 2, i.e. arranged with a distance d between the groups in the longitudinal direction x of the target 2.

## Description

### TECHNICAL FIELD

The present invention relates to a sputter coating device for depositing a coating layer on a substrate, comprising at least one target having a target surface, and a coating method comprising the step of providing a sputter coating device comprising at least one target having a sputter surface.

### PRIOR ART

Sputter coating devices and methods for depositing a thin layer on a substrate are known in the art. Generally, a sputter coating device comprises a stationary flat target or a cylindrical rotatable target for providing the coating material, a power supply for supplying power to the coating device and a substrate to be coated arranged in a direction facing the sputter surface of the target.

In order to increase the sputter rate of the coating device magnetron sputter coating devices have been introduced, wherein a magnetic field is generated above the sputter surface of the target. The magnetic field determines a plurality of plasma confinement zones having an increased ion density thus increasing the sputter rate. However, when using of a static magnetic field the erosion profile on the target surface is non-uniform and results in a non-uniform coating on the substrate as well as in a bad target utilization.

For this reason movable magnets being driven during the coating process in order to scan the target surface have been introduced.

However, the maximum power supply and the sputter rate are limited by the surface temperature of the target. In case of high temperatures, the target surface is damaged and effects like arcing may occur and make the target unusable.

European patent application No. 06124060.2 (not published), the content of which is incorporated herein by reference, discloses a method of decreasing the surface temperature of the target by considerably increasing the relative velocity between the target surface and the magnet assembly. Surprisingly, with this method the sputter rate could be increased without damaging the target surface.

### OBJECT OF THE INVENTION

It is an object of the present invention to provide a sputter coating device and a coating method for producing a thin film layer on a substrate having improved uniformity, at the same time reducing the temperature of the target surface and improving the target utilization.

### TECHNICAL SOLUTION

This object is achieved by providing a sputter coating device according to claim 1 and a sputter coating method according to claim 13. The dependent claims refer to features of particular embodiments of the invention.

The inventive sputter coating device for depositing a layer on a substrate, comprises at least one target having a sputter surface, and a plurality of magnet units movably arranged relative to said target to provide a magnetic field above said target surface.

By providing a plurality of magnet units, i.e. at least two magnet units, but particularly more than two magnet units, moving relative to the target a moving magnetic field and thus a moving plasma confinement zone (e.g. in the shape of a race track) is generated above the sputter surface of the target.

It has been discovered that by providing a plurality of magnet units the mean energy density supplied to the sputter surface of the target could be reduced and thus the surface temperature of the target may be reduced. This results in a more uniform target erosion and consequently in a more uniform layer thickness deposited on the substrate. Furthermore, the target utilization may be improved. Particularly, a theoretical value of the target utilization between 70 % and 75 % could be achieved which is considerably higher than the target utilization of conventional planar cathodes. The increased target utilization is due to the fact that the geometry and orientation of the magnetic field allows to avoid the development of hot spots (deep erosion areas) on the sputter surface of the target. The target utilization is quite uniform even near the edges of the target surface. Effects causing damage to the target surface such as arcing may be prevented efficiently.

In a preferred embodiment of the invention at least one magnet unit of said plurality of magnet units may be arranged to be movable relative to at least another magnet unit of said plurality of magnet units. Consequently, the magnet unit may move on a path parallel to at least one other magnet unit at the same speed or at a different speed, in the same or in the opposite direction, side-by-side or offset relative to the other magnet unit. The offset may be a substantially fixed or a varying distance between the magnet units.

Particularly, at least one magnet unit of said plurality of magnet units may be arranged to be movable independently from at least another magnet unit of said plurality of magnet units. An independent movement of the magnet units means that the magnet units may be moved with different speeds, in different directions, on separate paths and/or without being restricted in their movement by the other magnet units. The movement may be synchronous or asynchronous. A first group of the plurality of magnet units may be coupled in their movement and e.g. carry out a synchronous movement, whereas other magnet units may move independently from the first group of magnet units.

In another preferred embodiment the sputter coating device comprises a control unit for controlling the movement of said magnet units of said plurality of magnet units.

Particularly, said target is a flat target. The flat target has a flat sputter surface. It is preferred and a result of the present invention that the erosion profile of the flat sputter surface is as uniform as possible in order to deposit a coating layer having a uniform thickness on the substrate and to achieve good target utilization.

The plurality of magnet units is usually arranged on the side of the target opposite to the sputter surface of the target. In other words, at least two magnet units are arranged below a single target in order to generate a magnetic field on the other side of the target, i.e. above the sputter surface of the target. This is different from providing a number of targets with a distance between the targets and separate magnet units, one of them arranged below each of the targets.

In a preferred embodiment of the invention the magnet units are arranged to be movable along and/or parallel to a longitudinal axis of said target. If the target is a flat rectangular target the longitudinal axis is one of the axes of symmetry, particularly the longer axis of symmetry. Moving along the longitudinal axis allows higher speeds of movement of the magnet units when scanning a segment of the sputter surface of the target.

In another preferred embodiment of the present invention the magnet units of the plurality of magnet units are arranged to be movable relative to each other on substantially parallel paths.

Particularly, the magnet units are arranged adjacent to each other. Usually the magnet units are movable relative to each other on a path parallel to the path of movement of another magnet unit such that the movements of the magnet units do not interfere. On the other hand, the magnet units are arranged close to each other. The magnetic field generated by a first magnet unit may thus interfere with the magnetic field generated by another or other magnet units, particularly when the magnet units move near each other or pass each other.

In a preferred embodiment the target has a plurality of target segments, and each of said plurality of magnet units is arranged movable below a respective target segment to scan said target segment while being moved below said respective target segment. Thus the magnet units scan a respective portion (a tab) of the sputter surface of the target, particularly along the complete length of the target surface. The plurality of magnet units scans the complete sputter surface of the target during a coating process. Due to the fact that the magnet units may be moved independently from each other an optimized (variable) magnetic field may be calculated and generated for a particular coating process with many degrees of freedom.

Said sputter coating device may comprise a cathode. The cathode may include a plurality of (i.e. two or more) electrically independent cathode segments. The cathode segments may be electrically isolated from each other. Each of a plurality of magnet units may be arranged movable relative to a respective cathode segment. Each (real or virtual) cathode segment is assigned to one of the target segment and/or to one of the magnet units.

Said sputter coating device comprises a drive for driving said magnet units of said plurality of magnet units (3.1, 3.2, ..., 3.6), wherein said drive is configured to drive said magnet units with a speed exceeding 0.1 m/s, particularly 0.2 m/s, particularly 0.5 m/s, particularly 1.0 m/s, particularly 5.0 m/s.

In a preferred embodiment the sputter coating device comprises a drive for driving said magnet units of said plurality of magnet units, wherein said drive is configured to drive said magnet units with a speed exceeding 0.1 m/s, particularly 0.2 m/s, particularly 0.5 m/s, particularly 1.0 m/s, particularly 5.0 m/s. The best way to carry out the invention is to move the magnet units along a longitudinal axis of the target.

An inventive sputter coating method comprises the steps of: a) providing a sputter coating device comprising at least one target having a sputter surface, and a plurality of magnet units to provide a magnetic field above said sputter surface; and b) moving at least two magnet units of said plurality of magnet units relative to said sputter surface to provide a moving and/or fluctuating magnetic field above said target surface. The moving and/or fluctuating magnetic field is generated by the movement of the magnet units relative to the sputter surface and/or a movement of the magnet units relative to each other. The magnetic field is generated as a dynamic superposition of magnetic fields generated by the respective magnet units.

In a preferred embodiment of the invention said at least two magnet units of said plurality of magnet units may be moved relative to each other during step b).

Particularly, during step b) a first magnet unit of said at least two magnet units is moved independently from a second of said at least two magnet units.

Particularly, during process step b) the movement and/or the speed of said magnet units is controlled.

It is preferred that said target provided in process step a) is a flat target.

Particularly, the at least two magnet units are moved along and/or parallel to a longitudinal axis of said target.

It is preferred that during step b) said at least two magnet units move parallel to each other.

In a preferred embodiment, in step a) the at least two magnet units are arranged adjacent to each other such that they may pass each other while moving along their respective path of movement.

During step b) said at least two magnet units may scan the complete length of the sputter surface of the target.

In a preferred embodiment of the invention during step b) the at least two magnet units move with a speed exceeding 0.1 m/s, particularly 0.2 m/s, particularly 0.5 m/s, particularly 1.0 m/s, particularly 5.0 m/s, relative to the sputter surface of the target.

It is preferred that during step b) the at least two magnet units move relative to the sputter surface of the target having the same or different speed and/or having the same or opposite direction of movement and/or having a longitudinal displacement between the at least two magnet units. This means that the magnet units move synchronously or asynchronously during process step b).

In a synchronous movement the magnet units may move synchronously parallel relative to each other, i.e. without a longitudinal offset/displacement, having the same speed and direction of movement.

In another preferred embodiment of the invention the at least two magnet units move at the same speed and/or in the same direction of movement, but having a longitudinal displacement between at least two adjacent magnet units. There may be e.g. an alternating arrangement of magnet units. For example, there may be an arrangement of a first, a second, a third, a fourth, a.s.o. magnet unit arranged side-by-side along the lateral extension of the target. The first, the third, the fifth, etc. magnet units move without a longitudinal displacement relative to each other, i.e. they move synchronously. The second, fourth, sixth, etc. magnet units are arranged alternately with the first, the third, the fifth, etc. magnet units along the lateral extension of the target surface. The second, fourth, sixth, etc. magnet units move without a longitudinal displacement relative to each other, i.e. they move synchronously, but with a longitudinal displacement relative to the first, the third, the fifth, etc. magnet units.

In another embodiment of the invention the at least two magnet units move with different speed and/or having different directions of movement and/or having a longitudinal displacement between the at least two magnet units. The movement of the at least two magnet units may be asynchronous, independent from each other and/or irregular.

Especially when carrying out the relative of movement of the magnets with velocities relative to the target that exceed relatively high values a good performance, namely a uniform coating on the substrate and good target utilization, may be obtained. At the same time high temperature generation of the sputter surface of the target (e.g. hot spots) and thus damages of the target are prevented.

### BRIEF DESCRIPTION OF THE DRAWINGS

Further features and advantages of the invention will be apparent from the following description of preferred embodiments and the attached drawings. The drawings show:
- Fig. 1: a schematic view of a conventional target/magnet assembly;
- Fig. 2: a schematic view of a target/magnet assembly according to a first embodiment of the invention;
- Fig. 3: a schematic view of a target/magnet assembly according to a second embodiment of the invention;
- Fig. 4: a schematic view of a target/magnet assembly according to a third embodiment of the invention; and
- Fig. 5: a schematic view of a target/magnet assembly according to a fourth embodiment of the invention.

### DESCRIPTION OF PREFERRED EMBODIMENTS OF THE INVENTION

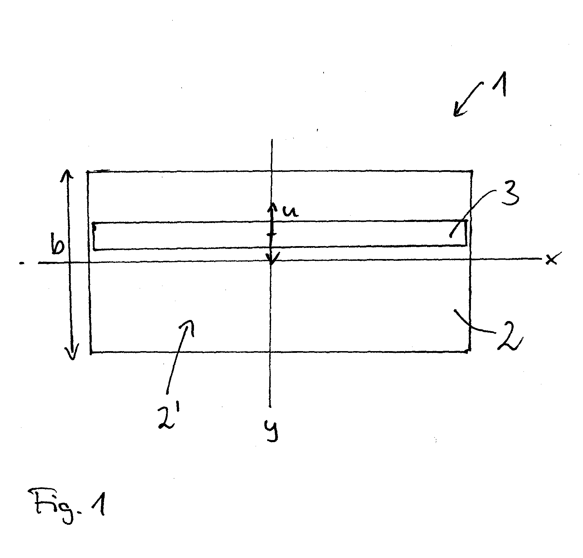

Fig. 1 illustrates a top view of a conventional target/magnet assembly 1.

A sputter target 2 of the target/magnet assembly 1 comprises a substantially flat and rectangular surface 2' having a longitudinal axis x and a lateral axis y. In order to increase the plasma density above the sputter surface 2' of the target 2 (i.e. the surface facing a substrate (not illustrated)), a magnet assembly 3 is arranged below the target 2. The magnet assembly 3 extends along the longitudinal axis x of the target 2.

In order to provide a uniform target erosion and thus deposit a coating having a uniform thickness on a substrate, the magnet system 3 reciprocates along the lateral axis y of the target 2 during the coating process with a predetermined velocity u of the movement of the magnet system 3. The magnet system 3 scans the surface 2' of the target 2 while a substrate facing the sputter surface 2' of the target 2 is coated.

However, the erosion profile generated on the sputter surface 2' of the target 2 and thus the uniformity of the coating layer provided on the substrate is insufficient. Furthermore, high temperature generated on the target surface 2' causes local damage (e.g. by arcing) on the surface 2' and even destroys the target.

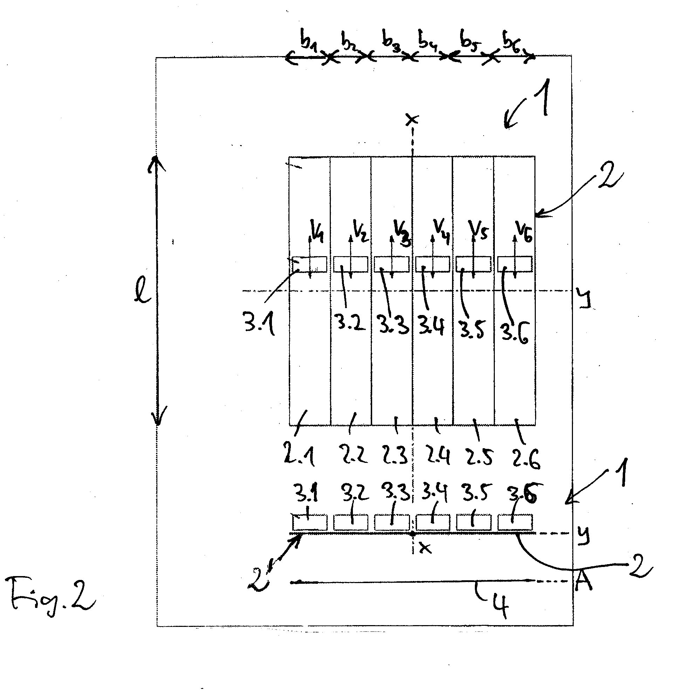

Fig. 2 illustrates a top view of a magnet/target assembly 1 according to the present invention, and a sectional view of the magnet/target assembly 1.

The magnet/target assembly 1 comprises a target 2 consisting of a plurality of (virtual) segments 2.1, 2.2, 2.3, 2.4, 2.5, 2.6 arranged side by side, each of them extending along the longitudinal axis x of the target 2. Each of the plurality of target segments 2.1, 2.2, 2.3, 2.4, 2.5, 2.6 has a magnet system 3.1, 3.2, 3.3, 3.4, 3.5, 3.6 attributed to the to the respective target segment.

In the first embodiment of the invention the magnet systems 3.1, 3.2, 3.3, 3.4, 3.5, 3.6 move parallel to the longitudinal axis x of the target 2 with a high speed v₁, _{V2}, v₃, _{V4}, v₅ and v₆, respectively, exceeding a speed of 0.1 m/s, particularly of 0.2 m/s, particularly of 0.5 m/s, while scanning the respective target segments 2.1, 2.2, 2.3, 2.4, 2.5 and 2.6, respectively.

The magnet systems 3.1, 3.2, 3.3, 3.4, 3.5, 3.6 move side by side in the same direction, reciprocating with the same speed v₁ = v₂ = v₃ = v₄ = v₅ = v₆ along their respective target segment 2.1, 2.2, 2.3, 2.4, 2.5, 2.6. The distance 1 of the movement of the magnet systems 3.1, 3.2, 3.3, 3.4, 3.5, 3.6 is considerably larger than the lateral extension b₁, b₂, b₃, b₄, b₅ and b₆ of the target segments 2.1, 2.2, 2.3, 2.4, 2.5 and 2.6, respectively.

It has been discovered that the high scanning speed v₁, v₂, v₃, v₄, v₅ and v₆ of the magnet systems 3.1, 3.2, 3.3, 3.4, 3.5, 3.6 results in an improved utilization of the target 2 and a better uniformity of the coating layer deposited on a substrate 4 arranged in a plane A and being arranged face-to-face with the sputter surface 2' of the target 2.

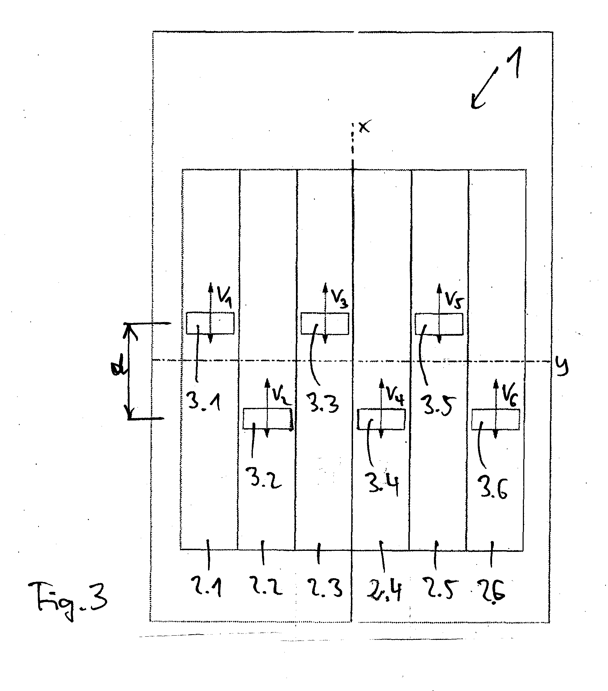

A second embodiment of the target/magnet assembly 1 according to the present invention is shown in Fig. 3. The magnet systems 3.1, 3.2, 3.3, 3.4, 3.5, 3.6 are arranged mutually offset relative to their respective adjacent magnet systems 3.1, 3.2, 3.3, 3.4, 3.5 and 3.6, respectively, while scanning the target segments 2.1, 2.2, 2.3, 2.4, 2.5 and 2.6, respectively. Particularly, the first magnet system 3.1, the third magnet system 3.3 and the fifth magnet system 3.5 are a first group of magnet systems moving parallel and synchronously with each other, and the second magnet system 3.2, the forth magnet systems 3.4 and the sixth magnet system 3.6 are a second group of magnet systems moving parallel and synchronously with each other. The first, third and fifth magnet systems 3.1, 3.3, 3.5 are alternately arranged with the second, forth and sixth magnet systems 3.2, 3.4 and 3.6, respectively, in the lateral direction y of the target 2. The paths of movement of the magnet systems are arranged parallel. The first and second groups of magnet systems 3.1, 3.2, 3.3, 3.4, 3.5, 3.6 are arranged offset in a longitudinal direction x of the target 2, i.e. arranged with a distance between the groups in the longitudinal direction x of the target 2.

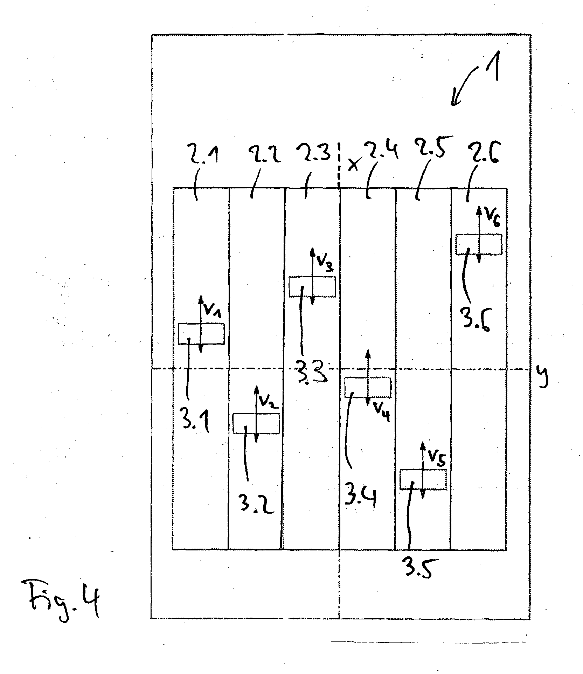

According to another embodiment of the present invention shown in Fig. 4 the magnet systems 3.1, 3.2, 3.3, 3.4, 3.5 and 3.6 of the magnet/target arrangement 1 move asynchronously with respect to each other, i.e. the magnet systems 3.1, 3.2, 3.3, 3.4, 3.5 and 3.6 are arranged longitudinally offset relative to each other during the coating process. The distances between the magnet systems 3.1, 3.2, 3.3, 3.4, 3.5 and 3.6 may be different and vary during the coating process. The speed and direction of movement may also differ.

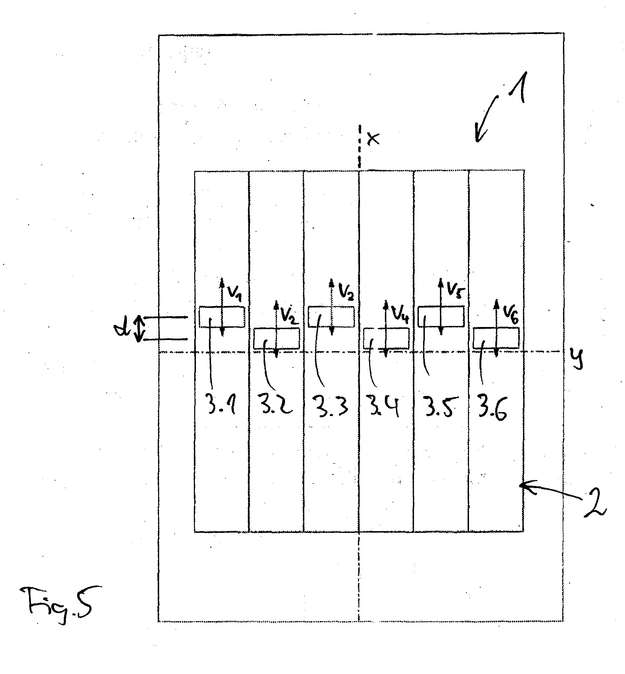

Another embodiment of the invention is illustrated in Fig. 5. The magnet/target assembly 1 comprises magnet systems 3.1, 3.2, 3.3, 3.4, 3.5 and 3.6 moving parallel to each other substantially in the same direction with a small longitudinal offset d between a first group of magnet systems 3.1, 3.3, 3.5 and a second group of magnet systems 3.2, 3.4 and 3.6. However, it is also possible that the first group of magnet systems 3.1, 3.3, 3.5 and the second group of magnet systems 3.2, 3.4 and 3.6 move parallel to each other (and to the longitudinal axis x of the target 2) in opposing directions.

By means of the present invention the target utilization may be improved. The magnet systems 3.1, 3.2, 3.3, 3.4, 3.5 and 3.6 move parallel to the longitudinal axis x and scan the length 1 of the target 2. By means of an independent movement of the target systems 3.1, 3.2, 3.3, 3.4, 3.5 and 3.6 arranged laterally offset from each other along the lateral extension b (b ≤ 1) of the target 2 the magnetic field may be, optimized to avoid hot spots (deep erosion areas) on the target 2. Furthermore, the uniformity of the thickness of a coating layer deposited on a substrate 4 may be controlled by selecting and generating a suitable geometry and orientation of the magnetic field. Therefore, the target 2 may be used/eroded with a homogenous rate even near the edges of the target 2. This results in a uniform profile of the thickness of the coating layer on the substrate 4.

The invention may be applied in a stationary coating process (with the substrate 4 being arranged stationary relative to the target 2 during the coating process), or in a dynamic coating process (with the substrate being moved relative to the target 2 during the coating process).

## Claims

1. A sputter coating device for depositing a coating layer on a substrate (4), comprising at least one target (2) having a sputter surface (2'),
**characterized in that** said sputter coating device comprises a plurality of magnet units (3.1, 3.2, ..., 3.6) movably arranged relative to said target (2) to provide a magnetic field above said target surface (2').

2. The sputter coating device according to claim 1,
**characterized in that** at least one magnet unit of said plurality of magnet units (3.1, 3.2, ..., 3.6) is arranged to be movable relative to at least another magnet unit of said plurality of magnet units (3.1, 3.2, ..., 3.6).

3. The sputter coating device according to claim 1 or 2,
**characterized in that** at least one magnet unit of said plurality of magnet units (3.1, 3.2, ..., 3.6) is arranged to be movable independently from at least another magnet unit of said plurality of magnet units (3.1, 3.2, ..., 3.6).

4. The sputter coating device according to any of the previous claims,
**characterized in that** the sputter coating device comprises a control unit for controlling the movement of said magnet units of said plurality of magnet units (3.1, 3.2, ..., 3.6).

5. The sputter coating device according to any of the previous claims,
**characterized in that** said target (2) is a flat target.

6. The sputter coating device according to any of the previous claims,
**characterized in that** said plurality of magnet units (3.1, 3.2, ..., 3.6) is arranged on a side of the target (2) opposite to the sputter surface (2') of the target (2).

7. The sputter coating device according to any of the previous claims,
**characterized in that** said magnet units of said plurality of magnet units (3.1, 3.2, ..., 3.6) are arranged to be movable along and/or parallel to a longitudinal axis (x) of said target (2).

8. The sputter coating device according to any of the previous claims,
**characterized in that** said magnet units of said plurality of magnet units (3.1, 3.2, ..., 3.6) are arranged to be movable relative to each other on substantially parallel paths.

9. The sputter coating device according to any of the previous claims,
**characterized in that** said magnet units of said plurality of magnet units (3.1, 3.2, ..., 3.6) are arranged adjacent to each other.

10. The sputter coating device according to any of the previous claims,
**characterized in that** said target (2) has a plurality of target segments (2.1, 2.2, ..., 2.6), and each of said plurality of magnet units (3.1, 3.2, ..., 3.6) is arranged movable below a respective target segment to scan said target segment while being moved below said respective target segment (2.1, 2.2, ..., 2.6).

11. The sputter coating device according to any of the previous claims,
**characterized in that** said sputter coating device comprises a cathode, wherein the cathode includes a plurality of electrically independent cathode segments.

12. The sputter coating device according to any of the previous claims,
**characterized in that** said sputter coating device comprises a drive for driving said magnet units of said plurality of magnet units (3.1, 3.2, ..., 3.6), wherein said drive is configured to drive said magnet units with a speed exceeding 0.1 m/s, particularly 0.2 m/s, particularly 0.5 m/s, particularly 1.0 m/s, particularly 5.0 m/s.

13. A coating method comprising the steps of:
a) providing a sputter coating device comprising at least one target (2) having a sputter surface (2'), and a plurality of magnet units (3.1, 3.2, ..., 3.6) to provide a magnetic field above said sputter surface (2') of said target (2); and
b) moving at least two magnet units of said plurality of magnet units (3.1, 3.2, ..., 3.6) relative to said sputter surface (2') to provide a moving/fluctuating magnetic field above said sputter surface (2').

14. The coating method according to claim 13,
**characterized in that** during step b) moving said at least two magnet units of said plurality of magnet units (3.1, 3.2, ..., 3.6) relative to each other.

15. The coating method according to claim 13 or 14,
**characterized in that** during step b) moving a first magnet unit of said at least two magnet units independently from a second of said at least two magnet units.

16. The coating method according to any of claims 13 to 15,
**characterized in that** during step b) controlling the movement and/or the speed of said magnet units.

17. The coating method according to any of claims 13 to 16,
**characterized in that** in step a) providing a flat target (2).

18. The coating method according to any of claims 13 to 17,
**characterized in that** during step b) moving at least two magnet units along and/or parallel to a longitudinal axis (x) of said target (2).

19. The coating method according to any of claims 13 to 18,
**characterized in that** during step b) moving at least two magnet units parallel to each other.

20. The coating method according to any of claims 13 to 19,
**characterized in that** in step a) arranging at least two magnet units adjacent to each other such that during step b) they pass each other while moving along their respective path of movement.

21. The coating method according to any of claims 13 to 20,
**characterized in that** during step b) said at least two magnet units scan the complete length (1) of the sputter surface (2') of said target (2).

22. The coating method according to any of claims 13 to 21,
**characterized in that** during step b) said at least two magnet units move with a speed exceeding 0.1 m/s, particularly 0.2 m/s, particularly 0.5 m/s, particularly 1.0 m/s, particularly 5.0 m/s, relative to the sputter surface (2') of said target (2).

23. The coating method according to any of claims 13 to 22,
**characterized in that** during step b) said at least two magnet units move relative to the sputter surface (2') of said target (2) having the same or different speed and/or having the same or opposite direction of movement and/or having a longitudinal displacement between the at least two magnet units.

## Amended claims

### Amended claims in accordance with Rule 137(2) EPC.

**1.** A sputter coating device for depositing a coating layer on a substrate (4), comprising at least one target (2) having a sputter surface (2'), wherein said sputter coating device comprises a plurality of magnet units (3.1, 3.2, ..., 3.6) movably arranged relative to said target (2) to provide a magnetic field above said target surface (2'),
**characterized in that**
said target (2) has a plurality of target segments (2.1, 2.2, ..., 2.6) having a longitudinal axis, and each of said plurality of magnet units (3.1, 3.2, ..., 3.6) is arranged movable below a respective target segment to scan said target segment while being moved below said respective target segment (2.1, 2.2, ..., 2.6), and
at least one of said magnet units (3.1, 3.2, ..., 3.6) is arranged longitudinally offset from at least another one of said magnet units (3.1, 3.2, ..., 3.6) and/or asynchronously movable with respect to at least another one of said magnet units (3.1, 3.2, ..., 3.6) and/or movable at different speed and/or in opposite directions of movement along said longitudinal axis of said respective target segment (2.1, 2.2, ..., 2.6).

**2.** The sputter coating device according to claim 1,
**characterized in that**
at least one magnet unit of said plurality of magnet units (3.1, 3.2, ..., 3.6) is arranged to be movable relative to at least another magnet unit of said plurality of magnet units (3.1, 3.2, ..., 3.6).

**3.** The sputter coating device according to claim 1 or 2,
**characterized in that**
at least one magnet unit of said plurality of magnet units (3.1, 3.2, ..., 3.6) is arranged to be movable independently from at least another magnet unit of said plurality of magnet units (3.1, 3.2, ..., 3.6).

**4.** The sputter coating device according to any of the previous claims,
**characterized in that**
the sputter coating device comprises a control unit for controlling the movement of said magnet units of said plurality of magnet units (3.1, 3.2, ..., 3.6).

**5.** The sputter coating device according to any of the previous claims,
**characterized in that**
said target (2) is a flat target.

**6.** The sputter coating device according to any of the previous claims,
**characterized in that**
said plurality of magnet units (3.1, 3.2, ..., 3.6) is arranged on a side of the target (2) opposite to the sputter surface (2') of the target (2).

**7.** The sputter coating device according to any of the previous claims,
**characterized in that**
said magnet units of said plurality of magnet units (3.1, 3.2, ..., 3.6) are arranged to be movable along and/or parallel to said longitudinal axis (x) of said target (2).

**8.** The sputter coating device according to any of the previous claims,
**characterized in that**
said magnet units of said plurality of magnet units (3.1, 3.2, ...,3.6) are arranged to be movable relative to each other on substantially parallel paths.

**9.** The sputter coating device according to any of the previous claims,
**characterized in that**
said magnet units of said plurality of magnet units (3.1, 3.2, ..., 3.6) are arranged adjacent to each other.

**10.** The sputter coating device according to any of the previous claims,
**characterized in that**
said sputter coating device comprises a cathode, wherein the cathode includes a plurality of electrically independent cathode segments.

**11.** The sputter coating device according to any of the previous claims,
**characterized in that**
said sputter coating device comprises a drive for driving said magnet units of said plurality of magnet units (3.1, 3.2, ..., 3.6), wherein said drive is configured to drive said magnet units with a speed exceeding 0.1 m/s, particularly 0.2 m/s, particularly 0.5 m/s, particularly 1.0 m/s, particularly 5.0 m/s.

**12.** A coating method comprising the steps of:
a) providing a sputter coating device comprising at least one target (2) having a sputter surface (2'), and a plurality of magnet units (3,1, 3.2, ..., 3.6) to provide a magnetic field above said sputter surface (2') of said target (2); and
b) moving at least two magnet units of said plurality of magnet units (3.1, 3.2, ..., 3.6) relative to said sputter surface (2') to provide a moving/fluctuating magnetic field above said sputter surface (2'),
**characterized in that**
during step b) said at least two magnet units move relative to the sputter surface (2') of said target (2) and are longitudinally displaced while moving and/or asynchronously moved and/or moved at different speed and/or moved in opposite directions of movement along said longitudinal axis of said respective target segment (2,1, 2.2, ..., 2.6).

**13.** The coating method according to claim 12,
**characterized in that**
during step b) moving said at least two magnet units of said plurality of magnet units (3.1, 3.2, .., 3.6) relative to each other.

**14.** The coating method according to claim 12 or 13,
**characterized in that**
during step b) moving a first magnet unit of said at least two magnet units independently from a second of said at least two magnet units.

**15.** The coating method according to any of claims 12 to 14,
**characterized in that**
during step b) controlling the movement and/or the speed of said magnet units.

**16.** The coating method according to any of claims 12 to 15,
**characterized in that**
in step a) providing a flat target (2).

**17.** The coating method according to any of claims 12 to 16,
**characterized in that**
during step b) moving at least two magnet units along and/or parallel to a longitudinal axis (x) of said target (2).

**18.** The coating method according to any of claims 12 to 17,
**characterized in that**
during step b) moving at least two magnet units parallel to each other.

**19.** The coating method according to any of claims 12 to 18,
**characterized in that**
in step a) arranging at least two magnet units adjacent to each other such that during step b) they pass each other while moving along their respective path of movement.

**20.** The coating method according to any of claims 12 to 19,
**characterized in that**
during step b) said at least two magnet units scan the complete length (1) of the sputter surface (2') of said target (2).

**21.** The coating method according to any of claims 12 to 20,
**characterized in that**
during step b) said at least two magnet units move with a speed exceeding 0.1 m/s, particularly 0.2 m/s, particularly 0.5 m/s, particularly 1.0 m/s, particularly 5.0 m/s, relative to the sputter surface (2') of said target (2).
